# EUROPEAN PATENT SPECIFICATION

(11) **EP 2 506 463 B1**
(45) Date of publication and mention of the grant of the patent: **01.05.2019**
(21) Application number: 12158544.2
(22) Date of filing: 08.03.2012
(51) Int. Cl.: H04H 20/22

(54) **METHOD FOR MANAGING ALTERNATIVE FREQUENCY LISTS AND APPARATUS FOR RDS**
VERFAHREN ZUR VERWALTUNG VON ALTERNATIVEN FREQUENZLISTEN UND VORRICHTUNG FÜR RDS
PROCÉDÉ DE GESTION DE LISTES DE FRÉQUENCES ALTERNATIVES ET APPAREIL POUR RDS

(30) Priority: 28.03.2011 KR 20110027461
(43) Date of publication of application: 03.10.2012
(73) Proprietor: Samsung Electronics Co., Ltd., Suwon-si, Gyeonggi-do, 443-742 (KR)
(72) Inventor: Kim, Jin Young, Gyeonggi-do (KR)
(74) Representative: HGF Limited

(56) References cited:
- EP-A2- 0 326 746
- US-A- 5 428 825
- US-B1- 6 711 390

## Description

### BACKGROUND OF THE INVENTION

### 1. Field of the Invention:

The present invention relates to a method for managing alternative frequency lists and an apparatus for a Radio Data System (RDS).

### 2. Description of the Related Art:

An RDS is a system for providing information services (such as a traffic information service, a paging service, and an automatic tuning) using a subcarrier of a Frequency Modulation (FM) broadcast. A terminal, such as mobile terminal and a navigation device can be configured to provide a user with the aforementioned information service using RDS data.

The RDS data may include an Alternative Frequency (AF) list, a broadcast station name, a nationality of station, and a Program Identification (PI) code identifies the station.

Typically, an RDS-enabled terminal provides an automatic tuning function to switch from the main frequency to one of alternative frequencies listed in the AF list. This means that the user does not need to retune the frequency, but the terminal measures the received signal strength of the main frequency and switches, when the received signal strength is equal to or less than a threshold value, to an alternative frequency, resulting in improvement of user convenience.

However, when the terminal measures the received signal strength of the alternative frequency and determines the PI code, a sound discontinuation effect occurs. The sound discontinuation is an effect in which no sound is heard for a few milliseconds or seconds in the middle of listening to the radio.

Typically, the alternative frequency-switching function is configured to be executed in an environment where the electric field does not vary abruptly. In such an environment, there is no need to determine the received signal strength of the main frequency so frequently that the received signal strength measurement cycle can be set to a relatively long time.

In a case where the long measurement cycle is applied in the environment wherein the electric field varies abruptly, the terminal cannot switch to an alternative frequency strong enough in the received signal strength in due time.

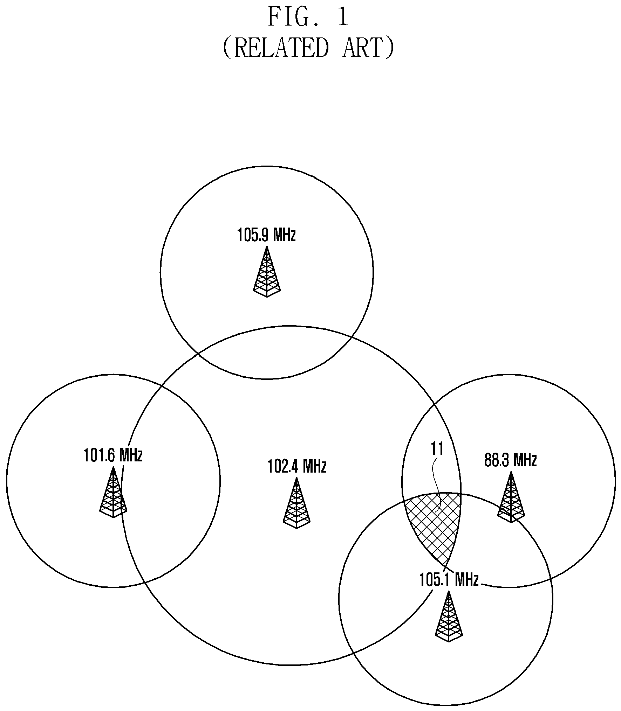

FIG. 1 illustrates a broadcasting system in which stations are overlapped in their radio coverage regions according to the related art.

Referring to FIG. 1, three frequencies, i.e., 102.4Mhz, 105.1Mhz, and 88.3Mhz, are overlapped in a region 11. In the region 11, the electric field varies abruptly such that the received signal strength of the main frequency is likely to decrease. At this time, the alternative frequency is likely to have a good signal strength and thus it is a good policy to switch to the alternative frequency quickly. For this purpose, the received signal strength determination cycle needs to be set to a short time.

However, if the received signal strength determination cycle is too short, the frequency switching occurs frequently, resulting in an increase of the number of sound discontinuations.

Especially in a building or basement, both the current and alternative frequencies become weak in strength. In this case, the frequency switching to the alternative frequency is likely to fail due to the weak signal strengths of both the current and alternative frequencies. If the terminal attempts frequency switching without consideration of such environment, the sound discontinuation effect occurs frequently without successful frequency switching.

The weak electric field environment may occur temporarily when the terminal passes through a tunnel or has change in antenna conditions. In such a case, since the electric field condition is recovered soon, maintaining the main frequency is preferred. However, the terminal of the related art attempts frequency switching repeatedly because the received signal strength of the current signal is poor without consideration that the poor signal condition can be recovered soon, resulting in frequency sound discontinuation effects.

There is therefore a need for an apparatus and a method for switching between frequencies in the RDS that is capable of reducing the occurrence of sound discontinuation effect in consideration of various radio listening environments. EP-0326746-A2 describes an RDS receiver which has a controller means for determining when no RDS wave can be received by the receiver at the present received frequency thereof for one of plural broadcasting stations constituting a network, and also that a change of the present received frequency to the frequency of another one of the broadcasting stations,
which is given by the AF data on the network of stations, has not been completed. The controller means provides an indication of this to the listener of the receiver if such determination is made.

US-6711390-B1 describes a method for processing transmitter and program related data in an FM RDS receiver, and a receiver executing the method, providing a band scanning search for detecting FM RDS transmitters exceeding a predetermined reception quality level.

US-5428825-A discloses a receiving frequency selecting method for a vehicle-mounted RDS receiver, wherein a list of alternative frequencies being transmitted by former broadcasting stations are stored in a memory, and the RDS receiver chases the same broadcast program based on the stored list of alternative frequencies whenever the motor vehicle returns to the same broadcasting service area of the network wherein the stored list of alternative frequencies is effective for use.

### SUMMARY OF THE INVENTION

Aspects of the present invention are to address at least the above-mentioned problems and/or disadvantages and to provide at least the advantages described below. Accordingly, an aspect of the present
invention is to provide a method for managing alternative frequency lists and an apparatus for a Radio Data System (RDS) that is capable of minimizing the occurrence of a sound discontinuation effect.

In accordance with an aspect of the present invention, a method for managing alternative frequency lists for a radio data system is provided. The method includes measuring a received signal strength of a main frequency, wherein the main frequency is a currently received frequency; receiving at least one alternative frequency list; establishing an accumulated alternative frequency list including all previously received alternative frequency lists; comparing the received signal strength of the main frequency with a predetermined reference received signal strength; and attempting, when the received signal strength of the main frequency is less than the reference received signal strength, switching to an alternative frequency in the accumulated alternative frequency list;
characterized in that attempting to switch to the alternative frequency comprises deleting the accumulated frequency list when the received signal strength of each of the alternative frequencies in the accumulated frequency list is less than a predetermined valid received signal strength.

In accordance with an aspect of the present invention, a radio data system (RDS) apparatus is provided. The RDS apparatus comprises: an RDS tuner arranged to receive a radio signal at a main frequency containing an alternative frequency list; an RDS data processing unit arranged to extract the alternative frequency list from the radio signal; an accumulated alternative frequency list database arranged to store an accumulated alternative frequency list including all previously received alternative frequency lists; and a frequency switching module arranged to:
establish the accumulated alternative frequency list; measure a received signal strength of the main frequency at a predetermined cycle; compare the received signal strength of the main frequency with a reference received signal strength; and attempt, when the received signal strength of the main frequency is less than the reference received signal strength, to switch to an alternative frequency in the accumulated alternative frequency list;
characterized in that the frequency switching module is further arranged to delete the accumulated frequency list when the received signal strength of each of the alternative frequencies in the accumulated frequency list is less than a predetermined valid received signal strength.

Other aspects, advantages, and salient features of the invention will become apparent to those skilled in the art from the following detailed description, which, taken in conjunction with the annexed drawings, discloses exemplary embodiments of the invention.

### BRIEF DESCRIPTION OF THE DRAWINGS

The above and other aspects, features, and advantages of certain exemplary embodiments of the present invention will be more apparent from the following description taken in conjunction with the accompanying drawings, in which:
FIG. 1 illustrates a broadcasting system in which stations are overlapped in their radio coverage regions according to the related art;
FIG. 2 is a block diagram illustrating a configuration of a terminal supporting a Radio Data System (RDS) according to an exemplary embodiment of the present invention;
FIG. 3 is a flowchart illustrating a method for managing alternative frequency lists of a terminal according to an exemplary embodiment of the present invention;
FIGs. 4A and 4B are flowcharts illustrating a frequency switching method of a terminal according to examples not forming part of the present invention;
FIGs. 5A and 5B are flowcharts illustrating a frequency switching method of a terminal according to examples not forming part of the present invention and
FIGs. 6A and 6B are flowcharts illustrating a frequency switching method of a terminal according to examples not forming part of the present invention.

Throughout the drawings, it should be noted that like reference numbers are used to depict the same or similar elements, features, and structures.

### DETAILED DESCRIPTION OF EXEMPLARY EMBODIMENTS

The following description with reference to the accompanying drawings is provided to assist in a comprehensive understanding of exemplary embodiments of the invention as defined by the claims. It includes various specific details to assist in that understanding but these are to be regarded as merely exemplary. Accordingly, those of ordinary skill in the art will recognize that various changes and modifications of the embodiments described herein can be made without departing from the scope of the invention. In addition, descriptions of well-known functions and constructions may be omitted for clarity and conciseness.

The terms and words used in the following description and claims are not limited to the bibliographical meanings, but, are merely used by the inventor to enable a clear and consistent understanding of the invention. Accordingly, it should be apparent to those skilled in the art that the following description of exemplary embodiments of the present invention is provided for illustration purpose only and not for the purpose of limiting the invention as defined by the appended claims and their equivalents.

It is to be understood that the singular forms "a," "an," and "the" include plural referents unless the context clearly dictates otherwise. Thus, for example, reference to "a component surface" includes reference to one or more of such surfaces.

By the term "substantially" it is meant that the recited characteristic, parameter, or value need not be achieved exactly, but that deviations or variations, including for example, tolerances, measurement error, measurement accuracy limitations and other factors known to those of skill in the art, may occur in amounts that do not preclude the effect the characteristic was intended to provide.

In exemplary embodiments of the present invention, the terms 'Received Signal Strength Indication (RSSI)' and 'received signal strength' denote the strength of the signal received by a Radio Data System (RDS) terminal.

In exemplary embodiments of the present invention, the terms 'reference RSSI' and 'reference received signal strength' denote the received signal strength to be referenced to determine whether to maintain the main frequency or to switch to an alternative frequency. For example, if the reference RSSI is 10 and if the RSSI of the main frequency is 9, the terminal attempts switching to an alternative frequency.

In exemplary embodiments of the present invention, the terms 'valid RSSI' and 'valid received signal strength' denote the received signal strength to be referenced to determine whether the corresponding frequency is listenable. For example, if the valid RSSI is 10 and if the RSSIs of the frequencies of 102.3MHz and 98.2MHz in the AF list are 9 and 11 respectively, the terminal determines that the RSSI of the frequency of 98.2MHz is a listenable frequency. In such case, the terminal performs frequency switching to the alternative frequency of which RSSI is greater than the valid RSSI.

In exemplary embodiments of the present invention, the terms 'Alternative Frequency (AF) list' and 'real time alternative frequency list' denote a list of the alternative frequencies that the terminal receives periodically while listening to the radio. The real time AF list is stored in a real time AF list database, and when the real time AF list is received, the terminal replaces the old real time AF list with the newly received real time AF list.

In exemplary embodiments of the present invention, the terms 'accumulated AF list' and 'accumulated alternative frequency list' denote the list of the alternative frequency list having the received alternative frequencies. The accumulated AF list is stored in an accumulated AF list database, and whenever the AF list is received, the terminal accumulates the AF list in the accumulated AF list database. At this time, the terminal compares the accumulated AF list and the received AF list and, if the AF list does not exist, adds the AF list. It is possible to set a maximum number of AFs that can be included in the accumulated AF list and, in this case, the terminal can configure the accumulated AF list with the maximum number of AFs.

In exemplary embodiments of the present invention, the terms 'AF RSSI list' and 'alternative frequency received signal strength list' denote the list of the received signal strengths of AFs that are measured by the terminal, and the terminal updates the AF RSSI list by adding only the RSSIs less than the valid RSSI.

In exemplary embodiments of the present invention, the terms 'good RSSI' and 'good received signal strength' denote a reference value for determining whether the current electric field condition is good. The good RSSI is set to a value less than the reference RSSI and valid RSSI. The terminal determines whether the proportion of the AFs of which RSSIs are equal to or greater than the good RSSI is equal to or greater than a predefined value and, if so, determines that the current electric field is good and thus maintains the accumulated AF list. Otherwise, if the proportion of the AFs of which RSSIs are equal to or greater than the good RSSI is equal to or greater than the predefined value, the terminal determines that the current electric field is not good and thus deletes the accumulated AF list.

In an exemplary embodiment of the present invention, the terminal can be any of a cellular terminal, a Portable Multimedia Player (PMP), a Personal Digital Assistant (PDA), a Motion Pictures Expert Group (MPEG-1 or MPEG-2) Audio Layer-3 (MP3) player, a navigation terminal, and their equivalents, that are equipped with an RDS tuner.

FIGs. 1 through 6B, discussed below, and the various exemplary embodiments used to describe the principles of the present disclosure in this patent document are by way of illustration only and should not be construed in any way that would limit the scope of the disclosure. Those skilled in the art will understand that the principles of the present disclosure may be implemented in any suitably arranged communications system. The terms used to describe various embodiments are exemplary. It should be understood that these are provided to merely aid the understanding of the description, and that their use and definitions in no way limit the scope of the invention. Terms first, second, and the like are used to differentiate between objects having the same terminology and are in no way intended to represent a chronological order, unless where explicitly stated otherwise. A set is defined as a non-empty set including at least one element.

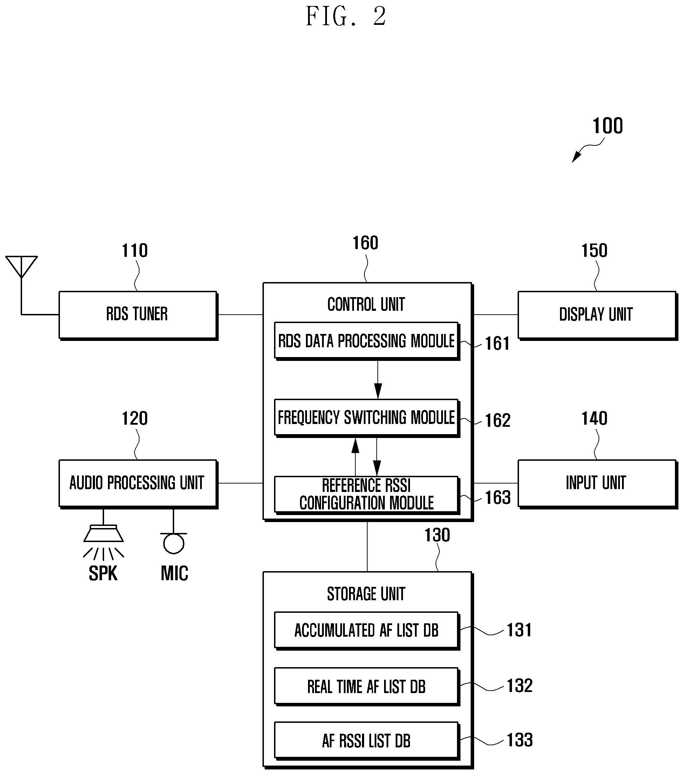

FIG. 2 is a block diagram illustrating a configuration of a terminal supporting an RDS according to an exemplary embodiment of the present invention.

Referring to FIG. 2, a terminal 100 may include an RDS tuner 110, an audio processing unit 120, a storage unit 130, an input unit 140, a display unit 150, and a control unit 160. The control unit 160 controls overall operations of the internal components of the terminal 100 and may include an RDS data processing module 161, a frequency switching module 162, and a reference RSSI configuration module 163. The storage unit 130 may include an accumulated AF list database 131, a real time AF list database 132, and an AF RSSI list database 133.

The RDS tuner 110 receives the radio data broadcast signal by means of an antenna under the control of the control unit 160 according to a broadcast channel selection or switching signal input through the input unit 140 by the user and outputs the radio data broadcast signal to the audio processing unit 120 and the RDS data processing module 161.

The audio processing unit 120 processes audio signals and includes a speaker (SPK) as an output part and a microphone (MIC) as an input part. The audio processing unit 120 includes a demodulation unit (not shown) and an amplification unit (not shown). The demodulation unit performs demodulation on the radio data broadcast signal input from the RDS tuner 110 and outputs an audio signal to the amplification unit. The amplification unit adjusts the volume of the audio signal input from the demodulation unit and outputs the audio signal through the SPK under the control of the control unit 160.

The storage unit 130 is responsible for storing programs and data needed for operations of the terminal 100 and is divided into a program region and a data region. The program region stores Operating System (OS) for controlling overall operations of the terminal 100 and application programs. The data region stores the data generated while the terminal 100 operates, such as audio and video data.

The accumulated AF list database 131 stores the accumulated AF list including all previously received AF lists. For example, if the terminal 100 receives the AF list including the frequencies of 92.2MHz and 105.9MHz and the AF list including 88.3MHz and 102.4MHz at the next cycle, the accumulated AF list database 131 stores the accumulated AF list including the frequencies of 92.2MHz, 105.9MHz, 88.3MHz, and 102.4MHz. The accumulated AF list database 131 can be configured with the maximum number of AF. When the terminal 100 attempts frequency switching, the accumulated AF list is used to select an AF.

The real time AF list database 132 stores the most recently received AF list received by the terminal 100. For example, if the terminal receives the AF list including the frequencies of 92.2MHz and 105.9MHz, the real time AF list database 132 stores the frequencies of 92.2MHz and 105.9MHz and, if the AF list including the frequencies of 88.3MHz and 102.4Mhz is received at the next cycle, the real time AF list database 132 is updated such that the frequencies of 92.2MHz and 105.9MHz are replaced by the frequencies of 88.3MHz and 102.4MHz. The terminal 100 uses the real time AF list as the reference to determine whether to perform frequency switching. According to an exemplary embodiment of the present invention, the real time AF list database 132, as the component of the terminal 100, can be omitted.

The AF RSSI list database 133 stores the AF RSSI list including the RSSIs less than the valid RSSI that is previously set among the RSSIs of the AFs measured by the terminal 100. If it is determined that the AF's RSSI measured by the terminal 100 is less than the valid RSSI, the terminal updates the AF RSSI list with the measured RSSI. According to an exemplary embodiment of the present invention, the AF RSSI list database 133 as a component of the terminal 100 can be omitted.

The input unit 140 receives the key manipulation signal input by the user for controlling the terminal 100 and delivers the signal to the control unit 160. The input unit 140 can be implemented with a keypad including buttons or a touch panel. The input unit 140 generates the input signal for executing applications executable in the terminal 100 to the control unit 160 in response to the user input. The display unit 150 can be implemented with one of a Liquid Crystal Display (LCD), Organic Light Emitting Diodes (OLEDs), and an Active Matrix OLED (AMOLED), and is a component for providing the user with graphic data. The display unit 150 displays radio application execution screen showing the information on the frequency to which the terminal 100 is tuned.

The RDS data processing module 161 extracts the RDS data containing the AF list from the radio data broadcast signal received by the RDS tuner 110 and outputs the RDS data to the frequency switching module 162.

The frequency switching module 162 performs switching to an AF by referencing the AF list received from the RDS data processing module 161. The frequency switching module 162 updates the accumulated AF list database 131 with the AF list received from the RDS data processing module 161. At this time, the frequency switching module 162 updates the accumulated AF list database 131 by adding the newly received AF list to all previously received AF lists.

The frequency switching module 162 measures the RSSI of the main frequency and, if the RSSI of the main frequency is less than the reference RSSI, attempts switching to the AF and measures the RSSIs of individual AFs of the accumulated AF list stored in the accumulated AF list database 131 in sequence. The frequency switching module 162 measures the RSSI of an AF and, if the measured RSSI is greater than a predefined valid RSSI, determines whether the Program Identification (PI) code of the AF is identical with the PI code of the main frequency and, if the PI codes are identical with each other, performs switching to the AF.

The frequency switching module 162 measures the RSSI of an AF and, if the measured RSSI is less than the valid RSSI, determines whether the RSSI measurement has been performed to all of the AFs in the accumulated AF list. If it is determined that the RSSI measurement has been performed to all of the AFs, the frequency switching module 162 deletes the accumulated AF list stored in the accumulated AF list database 131 and reconfigures the accumulated AF list using the received AF list.

If it is determined that the PI codes differ from each other, the code frequency switching module 162 can measure the RSSI of the next AF in the accumulated AF list. According to an example not forming part of the present invention, if the PI codes differ from each other, the frequency switching module 162 repeats the PI code identification process up to a predefined number of times and, if there is no matched PI, measures RSSI of the next AF in the accumulated AF list.

According to an example not forming part of the present invention, the frequency switching module 162 can update the real time AF list database 132 as well as the accumulated AF list database 131 with the received AF list. When updating the real time AF list database 132, the frequency switching module 162 replaces the real time AF list stored in the real time AF list database 132 with the newly received AF list.

If the RSSI of the main frequency is less than the reference RSSI, the frequency switching module 162 determines whether at least one AF exists in the real time AF list database 132 and, if so, attempts frequency switching to the AF. The frequency switching module 162 measures the RSSIs of the AFs in the accumulated AF list and stores the RSSIs of the AFs, which are less than the valid RSSI in the AF RSSI list database 133. If it is determined that the RSSIs of the entire AFs in the accumulated AF list are less than the valid RSSI, the frequency switching module 162 determines whether the proportion of the AFs of which RSSIs are equal to or greater than the good RSSI is equal to or greater than a predefined value. If so, the frequency switching module 162 maintains the accumulated AF list and, otherwise, deletes the accumulated AF list stored in the accumulated AF list database 131.

The reference RSSI configuration module 163 is a component for configuring the reference RSSI. Once the radio application is executed, the reference RSSI configuration module 163 sets the reference RSSI to the first value. The frequency switching module 162 measures the RSSIs of all AFs in the accumulated AF list and, if the RSSIs are less than the valid RSSI, transfers a reference RSSI change signal to the reference RSSI configuration module 163, and the reference RSSI configuration module 163 sets the reference RSSI to a second value which is less than the first value. After setting the reference RSSI to the second value, the reference RSSI configuration module 163 starts a timer, and after a predefined time (T) elapses, resets the reference RSSI to the first value.

Hereinafter, with the knowledge of the above-described configuration of the terminal 100, a description is made of the frequency switching procedure of the terminal 100.

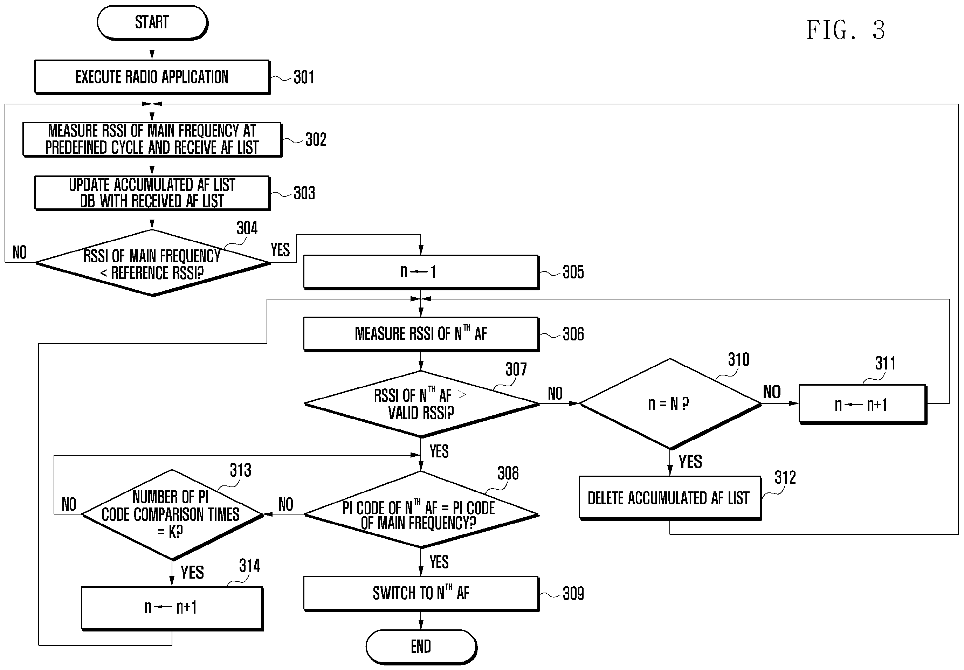

FIG. 3 is a flowchart illustrating a frequency switching method of a terminal according to an exemplary embodiment of the present invention.

Referring to FIG. 3, the frequency switching method suitable for an environment where the received signal strength decreases when moving in the region multiple frequencies are overlapped is illustrated.

The control unit 160 executes the radio application at step 301. The control unit 160 detects the user command input by means of the input unit 140 and executes the radio application.

The frequency switching module 162 measures the RSSI of the main frequency by means of the RDS tuner 110 at a predefined cycle and receives the AF list at step 302. The RDS tuner 110 receives the radio data broadcast signal including the AF list from a broadcast station and delivers the radio data broadcast signal to the RDS data processing module 161 and frequency switching module 162. The RDS processing module 161 extracts the AF list from the radio data broadcast signal and transfers the radio data broadcast signal to the frequency switching module 162, and the frequency switching module 162 measures the RSSI of the radio data broadcast signal received by the RDS tuner 110. It is preferred that the RSSI measurement of the main frequency and the receipt of the AF list are performed at a cycle equal to or shorter than 5 seconds (e.g., 3 seconds). In the environment where the received signal strength decreases abruptly, the RSSI of the main frequency needs to be checked frequently.

The frequency switching module 162 updates the accumulated AF list database 131 with the received AF list at step 303. The accumulated AF list database 131 stores all previously received accumulated AF lists and is updated by accumulating the newly received AF list. The frequency switching module 162 compares the accumulated AF lists and the newly received AF list to update the accumulated AF list database 131 without overlapping of the AF lists. According to an exemplary embodiment of the present invention, a maximum number of AFs of the accumulated AF list can be set and, in this case, the frequency switching module 162 can configure the accumulated AF list with up to the maximum number of AFs. For example, if the maximum number of AF is set to 25, the frequency switching module 162 can establish the AF list with up to 25 AFs.

The frequency switching module 162 compares the RSSI of the main frequency and a predefined reference RSSI at step 304. According to an exemplary embodiment of the present invention, the reference RSSI denotes the received signal strength to be referenced for determining whether to maintain the main frequency or switch to an AF. If it is determined that the RSSI of the main frequency is less than the reference RSSI, the frequency switching module 162 attempts switching to the AF. For example, if the reference RSSI is 10 and the RSSI of the main frequency is 9, the frequency switching module 162 performs switching to the AF.

During the attempted switching to the RS, the frequency switching module 162 sets n (index of the AF in the AF list) to 1 at step 305. This means that the first AF of which RSSI is measured is selected from the accumulated AF. The frequency switching module 162 measures the RSSI of the n^{th} AF at step 306. If n is set to 1, the frequency switching module 162 measures the RSSI of the first AF.

The frequency switching module 162 determines whether the RSSI of the n^{th} AF is equal to or greater than the valid RSSI at step 307. According to an exemplary embodiment of the present invention, the valid RSSI denotes the RSSI to be referenced to determine whether the RSSI of each AF in the accumulated AF list is good enough to listen to the corresponding AF.

If it is determined that the RSSI of the n^{th} AF is equal to or greater than the valid RSSI, the frequency switching module 162 determines whether the PI code of the n^{th} AF matches with the PI code of the main frequency at step 308. If the PI code of the n^{th} AF matches with the PI code of the main frequency, the frequency switching module 162 performs switching to n^{th} AF at step 309.

If it is determined that the RSSI of the n^{th} AF is less than the valid RSSI, the frequency switching module 162 determines whether n is equal to N at step 310. That is, the frequency switching module 162 determines whether the RSSI measurement has been performed to all of the AFs in the accumulated AF list at step 310. If it is determined that n is not equal to N, the frequency switching module 162 increments n by 1 at step 311. That is, the frequency switching module 162 selects the next AF for measuring the RSSI. The frequency switching module 162 returns to step 306 to measure the RSSI of the n^{th} AF (AF having the next index).

If it is determined at step 310 that the RSSI measurement has been performed to all of the AFs in the accumulated AF list, the frequency switching module 162 deletes the accumulated AF list from the accumulated AF list database 131 at step 312. The frequency switching module receives the AF list at the predefined cycle at step 302 and establishes a new accumulated AF list at step 303.

If it is determined that the PI code of the n^{th} AF does not match with the PI code of the main frequency at step 308, the frequency switching module 162 determines whether a number of PI code comparison times has
reached a predefined value (K) at step 313. In the first example not forming part of the present invention, the frequency switching module 162 performs the PI code comparison multiple times. Although the PI codes of the main frequency and AF match with each other, if the electric field is unstable, it is possible to determine the PI codes are not matching with each other. In order to avoid such a determination error, the frequency switching module 162 can perform the PI code comparison several times. The number of PI code comparison time is preferably set to 5.

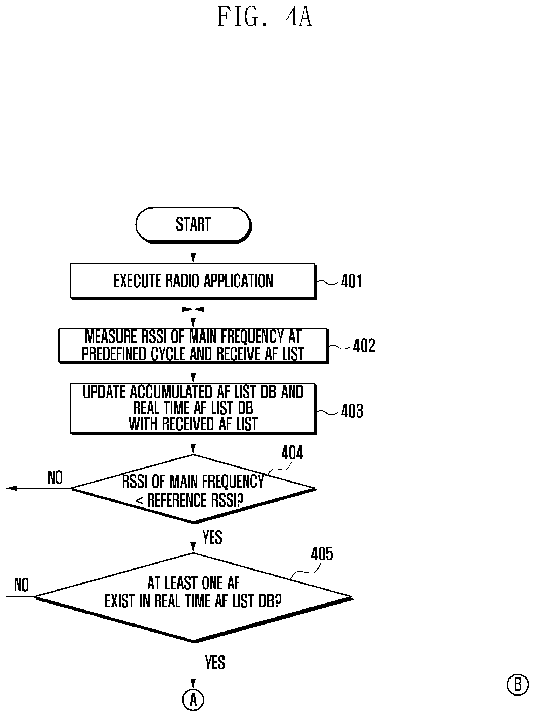

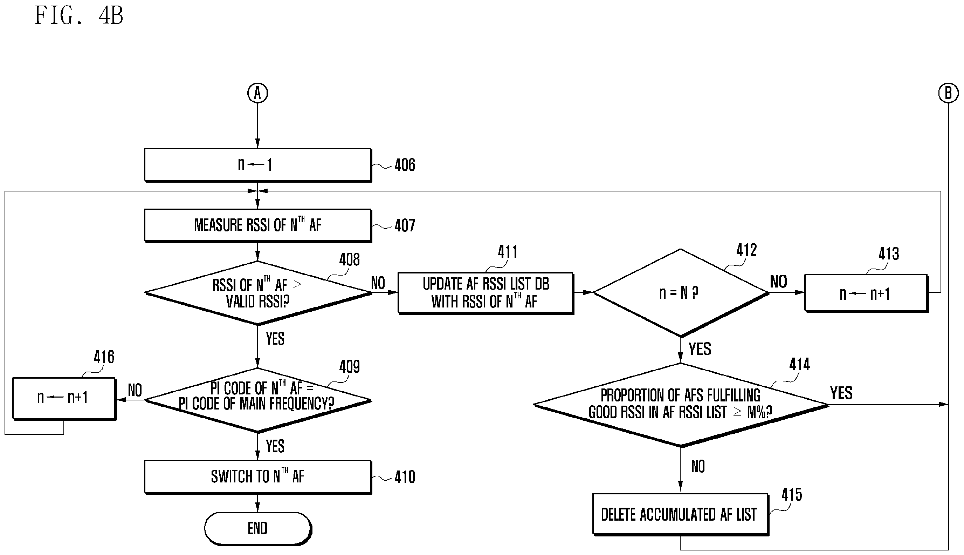

If the PI code comparison times has reached K, the frequency switching module 162 increments n by 1 at step 314. That is, the frequency switching module 162 selects the next AF of which RSSI is to be measured. The frequency switching module 162 returns to step 306 to measure the RSSI of the n^{th} AF (AF having the next index). Since the main frequency's RSSI measurement cycle is set to 3 seconds in the first exemplary embodiment of the present invention, it is possible to attempt switching to the AF quickly in the environment where the received signal strength decreases abruptly. With the use of the accumulated AF list as well as the real time AF list, the number of selectable AFs increases, resulting in improvement of probability of switching to AF. In addition, by performing the PI code comparison process several times, it is possible to reduce the error occurrence probability as compared to the case when the PI code comparison is performed one time. FIGs. 4A and 4B are flowcharts illustrating a frequency switching method of a terminal according to examples not forming part of the present invention. Referring to FIGs. 4A and 4B, the frequency switching method suitable for an environment where a weak electric field is constantly maintained, such as a subway, indoors, and a basement of a building, is illustrated.

The control unit 160 executes the radio application at step 401, and the frequency switching module 162 measures RSSI of the main frequency received by means of the RDS tuner 110 at a predefined cycle and receives the AF list at step 402.

The frequency switching module 162 updates the accumulated database 131 and the real time AF list database 132 with the received AF list at step 403. The accumulated AF list database 132 stores the accumulated AF list including all previously received AF lists, and the real time AF list database stores only the newly received AF list. In order to update the real time AF list database 132, the frequency switching module 162 replaces the previously stored AF list with the newly received AF list.

The frequency switching module 162 compares the main frequency RSSI and a predefined reference RSSI and determines whether the RSSI of the main frequency is less than the reference RSSI at step 404.

If the RSSI of the main frequency is less than the reference RSSI, the frequency switching module 162 determines whether the real time AF list database 132 has at least one AF at step 405. If the RSSI of the main frequency is equal to or greater than the reference RSSI, the frequency switching module 162 does not attempt switching to the AF but returns to step 402 to measure the RSSI of the main frequency at a predefined cycle and receive the AF list.

If the real time AF list database 132 has at least one AF at step 405, the frequency switching module 162 sets n (AF index in AF list) to 1 at step 406. In contrast, if the real time AF list database 132 has no AF at step 405, the frequency switching unit 162 does not attempt switching to the AF but returns to step 402 to measure the RSSI of the main frequency at a predefined cycle and receives the AF list. If the real time AF list database 132 has no AF, this means that it is not the condition to switch to the AF.

The frequency switching unit 162 measures RSSI of the n^{th} AF at step 407. If n is set to 1, the frequency switching module 162 measures the RSSI of the first AF. The frequency switching module 162 determines whether the RSSI of the n^{th} AF is equal to or greater than a predefined valid RSSI at step 408. If the RSSI of the n^{th} AF is equal to or greater than the valid RSSI, the frequency switching module 162 determines whether the PI code of the n^{th} AF matches with the PI code of the main frequency at step 409. If the PI codes of the n^{th} AF and the main frequency match with each other, the frequency switching module 162 performs switching to the n^{th} AF at step 410.

If the RSSI of the n^{th} AF is less than the valid RSSI at step 408, the frequency switching module 162 updates the AF RSSI list database 133 by adding the RSSI of the n^{th} AF at step 411. In an example not forming part of the present invention, the AF RSSI list may include the RSSIs that are individually less than the valid RSSI among RSSIs measured by the frequency switching module 162 and used as the reference to determining whether to attempt switching to the AF.

The frequency switching module 162 determines whether n has reached N at step 412. That is, the frequency switching module 162 determines whether the RSSI measurement has been performed on all of the AFs in the accumulated AF list at step 412. If it is determined that n has not reached N at step 412, the frequency switching module 162 increments n by 1 at step 413. That is, the frequency switching module 162 selects the AF to measure the RSSI thereof. After incrementing n by 1, the procedure goes to step 407 to measure RSSI of the n^{th} AF (AF having the next index).

In contrast, if it is determined that n has reached N at step 412, the frequency switching module 162 determines whether the proportion of the AFs fulfilling the condition of good RSSI in the accumulated AF list is equal to or greater than a predefined proportion (M) % at step 414. According to an example not forming part of the present invention, the good RSSI as the reference value for determining the current electric field condition may be set to a value less than the reference RSSI and valid RSSI. The frequency switching module 162 determines whether the proportion of the RSSIs equal to or greater than the good RSSI is equal to or greater than M %.

If the proportion of the RSSIs equal to or greater than the good RSSI is less than M %, the frequency switching module 162 determines that the current electric field is poor and deletes the accumulated AF list from the accumulated AF list database 131 at step 415. After deleting the accumulated AF list, the procedure goes to step 402 to receive the AF list at the predefined cycle and configures the accumulated AF list and real time AF list.

If the proportion of the RSSIs equal to or greater than the good RSSI is equal to or greater than M%, the frequency switching module 162 determines that the current electric field condition is good so as to maintain the accumulated AF list and returns to step 402.

If the PI codes of the n^{th} AF and the main frequency differ from each other at step 409, the frequency switching module 162 increments n by 1 at step 416. That is, the frequency switching module 162 selects the next AF to measure the

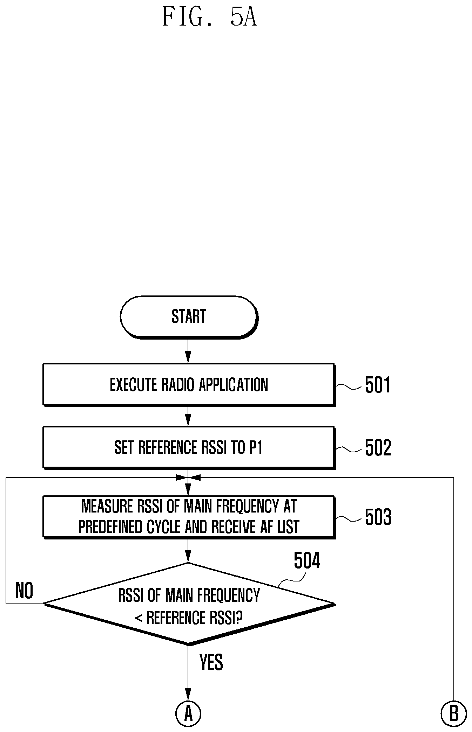

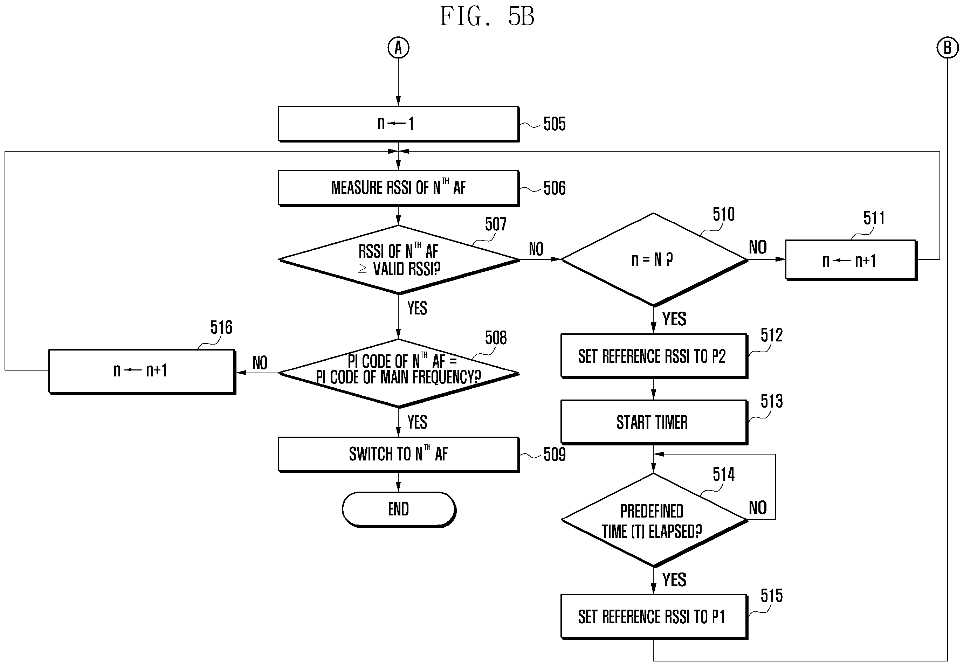

RSSI thereof. Thereafter, the frequency switching module 162 measures the RSSI of the n^{th} AF (AF having the next index) at step 407. In the second example not forming part of the present invention, the terminal 100 determines whether the proportion of the AFs of which RSSIs are individually equal to or greater than the good RSSI is equal to or greater than a predefined value and, if not, deletes the accumulated AF list to avoid an unnecessary switching attempt to an AF. In addition, since the real time AF list is used along with the accumulated AF list and the frequency switching is attempted when at least one AF exists in the real time list, it is possible to reduce the number of unnecessary switching attempts to the AF. FIGs. 5A and 5B are flowcharts illustrating a frequency switching method of a terminal according to examples not forming part of the present invention. Referring to FIGs. 5A and 5B, the frequency switching method suitable for an environment where the electric field is temporarily weakened by a cause, such as holding the antenna of the terminal 100, is illustrated.

The control unit 160 executes the radio application at step 501, and the reference RSSI configuration module 163 sets the reference RSSI to P1 at step 502. P1 is a default value of the reference RSSI, and the reference RSSI configuration module 163 sets the reference RSSI to P1 when the radio application is executed initially.

The frequency switching module 162 measures the RSSI of the main frequency and receives the AF list by means of the RDS 110 at a predefined cycle at step 503. The frequency switching module 162 compares the RSSI of the main frequency with a predefined reference RSSI to determine whether the RSSI of the main frequency is less than the reference RSSI at step 504.

If the RSSI of the main frequency is less than the reference RSSI, the frequency switching module 162 sets n (AF index in AF list) to 1 at step 505. In contrast, if the RSSI of the main frequency is equal to or greater than the reference RSSI at step 504, the frequency switching module 162 does not attempt switching to an AF but returns to step 503 to measure the RSSI of the main frequency at a predefined cycle and receive the AF list.

The frequency switching module 162 measures the RSSI of the n^{th} AF. If n is set to 1, the frequency switching module 162 measures the RSSI of the first AF at step 506. The frequency switching module 162 determines whether the RSSI of the n^{th} AF is equal to or greater than a predefined valid RSSI at step 507. If the RSSI of the n^{th} AF is equal to or greater than the valid RSSI, the frequency switching module 162 determines whether the PI code of the n^{th} AF matches with the PI code of the main frequency at step 508. If the PI codes of the n^{th} AF and the main frequency match with each other, the frequency switching module 162 performs switching to n^{th} AF at step 509.

If the RSSI of the n^{th} AF is less than the valid RSSI at step 507, the frequency switching module 162 determines whether n has reached N at step 510. That is, the frequency switching module 162 determines whether the RSSI measurement has been performed on all of the AFs in the accumulated AF list at step 510. If n has not reached N at step 510, the frequency switching module 162 increments n by 1 at step 511. That is, the frequency switching module 162 returns to step 506 to select the next AF to measure the RSSI thereof.

In contrast, if n has reached N at step 510, the frequency switching module 162 sends the reference RSSI configuration module 163 a signal including the information on that the RSSI of each of the AFs in the accumulated AF list is less than the valid RSSI, and the reference RSSI configuration module
163 sets the reference RSSI to P2 at step 512. According to an example not forming part of the present invention, P2 may be a value less than P1. For example, P1 can be set to 10 while P2 is set to 2. The reference RSSI configuration module 163 starts a timer at step 513 and determines whether a predefined time (T) has elapsed at step 514. If the predefined time T has elapsed at step 514, the reference RSSI configuration module 163 resets the reference RSSI to P1 at step 515.

When it is required to compare the RSSI of the main frequency with the reference RSSI, the frequency switching module 162 compares the RSSI of the main frequency with P1 or P2.

If the PI code of the n^{th} AF matches with the PI code of the main frequency at step 508, the frequency switching module 162 increments n by 1 at step 516. That is, the frequency switching module 162 selects the next AF to measure the RSSI thereof. The frequency switching module 162 returns to step 506 to measure the RSSI of the n^{th} AF (AF having the next index).

In the third example not forming part of the present invention, the terminal 100 decreases the reference RSSI under a specific condition to avoid unnecessary switching attempts to an AF and increases the reference RSSI back after a predefined time to dynamically perform the switching to AF according to the situation.

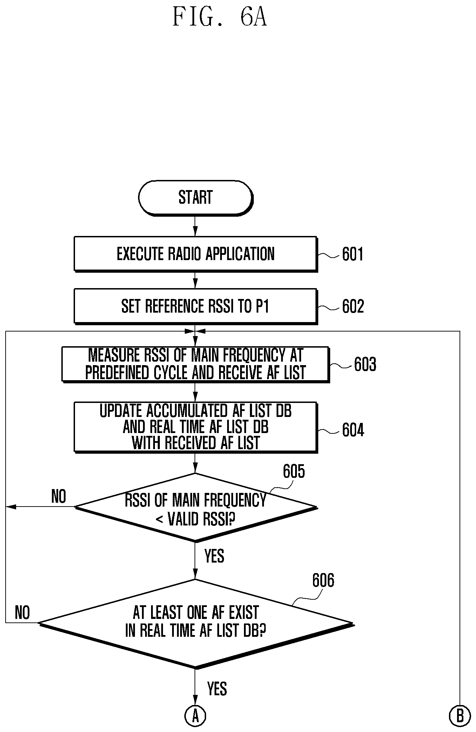

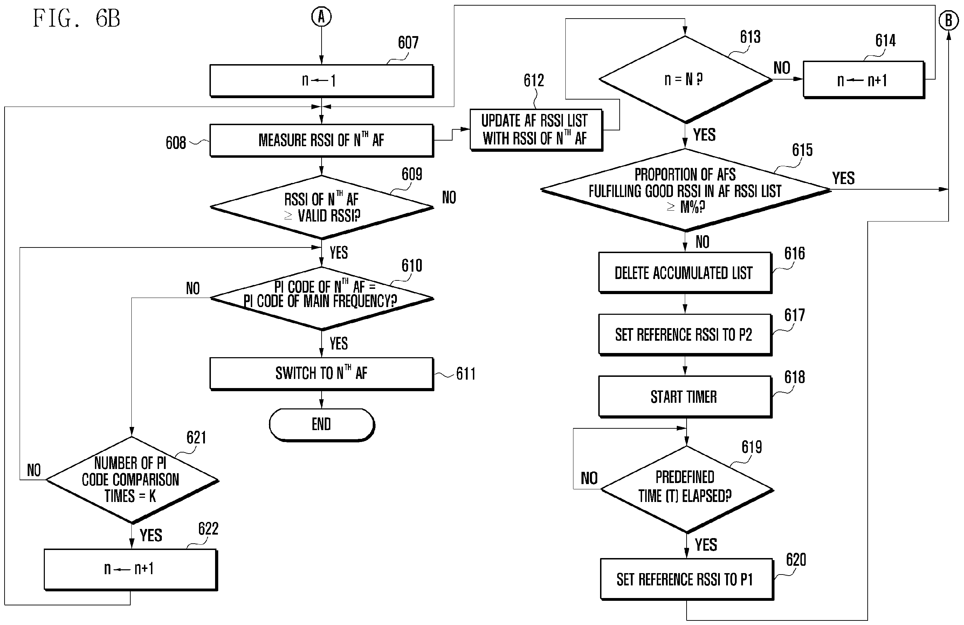

FIGs. 6A and 6B are flowcharts illustrating a frequency switching method of a terminal according to examples not forming part of the present invention. Referring to FIGs. 6A and 6B, the frequency switching method generalizing the first through third example not forming part of the present invention is illustrated. The control unit 160 executes the radio application at step 601, and the reference RSSI configuration module 163 sets the reference RSSI to P1 at step 602. The frequency switching module 162 measures the RSSI of the main frequency at a predefined cycle and receives the AF list by means of the RDS tuner 110 at step 603.

The frequency switching module 162 updates the accumulated AF list database 131 and the real time AF list database 132 with the AF list at step 604. The frequency switching module 162 updates the real time AF list database 132 by replacing the previously stored AF list with the newly received AF list.

The frequency switching module 162 compares the RSSI of the main frequency with a predefined reference RSSI to determine whether the RSSI of the main frequency is less than the reference RSSI at step 605. If the main frequency RSSI is less than the reference RSSI, the frequency switching module 162 determines whether the real time AF list database 132 has at least one AF at step 606. If the RSSI of the main frequency is equal to or greater than the reference RSSI, the frequency switching module 162 does not attempt switching to the AF but returns to step 603 to measure the RSSI of the main frequency at a predefined cycle and receive the AF list.

If the real time AF list database 132 has at least one AF at step 606, the frequency switching module 162 attempts switching to the AF and sets n (AF index in AF list) to 1 at step 607. This is the process to select the first AF to measure the RSSI thereof. In contrast, if the real time AF list database 132 has no AF at step 606, the frequency switching unit 162 does not attempt switching to the AF but returns to step 603. If there is no AF in the real time AF list database 132, this means that the current situation is not the situation for switching to the AF.

The frequency switching module 162 measures the RSSI of the n^{th} AF at step 608. If n is set to 1, the frequency switching module 162 measures the RSSI of the first AF. The frequency switching module 162 determines whether the RSSI of the n^{th} AF is equal to or greater than a predefined valid RSSI at step 609. If the RSSI of the n^{th} AF is equal to or greater than the valid RSSI, the frequency switching module 162 determines whether the PI code of the n^{th} AF matches with the PI code of the main frequency at step 610. If the two PI codes match with each other, the frequency switching module 162 performs switching to the n^{th} AF at step 611.

If the RSSI of the n^{th} AF is less than the valid RSSI at step 609, the frequency switching module 162 updates the AF RSSI list database 133 with the RSSI of the n^{th} AF at step 612. The frequency switching module 162 determines whether n has reached to N at step 613. That is, the frequency switching module 162 determines whether the RSSI measurement has been performed to all of the AF in the accumulated AF list at step 613. If n has not reached N at step 613, the frequency switching module 162 increments n by 1 at step 614. That is, the frequency switching module 162 selects the next AF to measure the RSSI thereof. The frequency switching module 162 returns to step 608 to measure the RSSI of the n^{th} AF (AF having the next index).

In contrast, if n has reached N at step 613, the frequency switching module 162 determines whether the proportion of the AFs fulfilling the condition of good RSSI in the accumulated AF list is equal to or greater than a predefined proportion (M) % at step 615. If the proportion of the RSSIs equal to or greater than the good RSSI is less than M%, the frequency switching module 162 determines that the current electric field is poor and deletes the accumulated AF list from the accumulated AF list database 131 at step 616. After deleting the accumulated AF list, the frequency switching module 162 sends the reference RSSI configuration module 163 a signal including the information on that the RSSI of each of the AFs in the accumulated AF list is less than the valid RSSI, and the reference RSSI configuration module 163 sets the reference RSSI to P2 at step 617. The reference RSSI configuration module 163 starts a timer at step 618 and determines whether a predefined time (T) has elapsed at step 619. If the time T has elapsed at step 619, the reference RSSI configuration module 163 resets the reference RSSI to P1 at step 620.

If the PI code of the n^{th} AF matches with the PI code of the main frequency at step 610, the frequency switching module 162 determines whether a number of PI code comparison times has reached a predefined value (K) at step 621. If the PI code comparison times has reached K, the frequency switching module 162 increments n by 1 at step 622. That is, the frequency switching module 162 selects the next AF of which RSSI is to be measured. The frequency switching module 162 returns to step 608 to measure the RSSI of the n^{th} AF (AF having the next index).

According to an exemplary embodiment of the present invention, a terminal performs switching to an alternative frequency in consideration of a radio listening environment, thereby reducing unnecessary frequency switching operations and minimizing the sound discontinuation effect caused by frequency switching.

While the invention has been shown and described with reference to certain exemplary embodiments thereof, it will be understood by those skilled in the art that various changes in form and details may be made therein without departing from the scope of the invention as defined by the appended claims.

## Claims

1. A method for managing alternative frequency lists for a radio data system, the method comprising:
measuring (302) a received signal strength of a main frequency, wherein the main frequency is a currently received frequency;
receiving (302) at least one alternative frequency list;
establishing (303) an accumulated alternative frequency list including all previously received alternative frequency lists;
comparing (304) the received signal strength of the main frequency with a reference received signal strength; and
attempting, when the received signal strength of the main frequency is less than the reference received signal strength, to switch (309) to an alternative frequency in the accumulated alternative frequency list;
**characterized in that**
attempting to switch to the alternative frequency comprises deleting the accumulated frequency list when the received signal strength of each of the alternative frequencies in the accumulated frequency list is less than a predetermined valid received signal strength.

2. The method of claim 1, wherein attempting to switch (309) to the alternative frequency comprises:
measuring (306) the received signal strengths of alternative frequencies in the accumulated alternative frequency list in sequence;
determining (308), when the measured received signal strength of an alternative frequency is equal to or greater than the valid received signal
strength, whether a Program Identification, PI, code of the alternative frequency matches with the PI code of the main frequency; and
performing (309), when the PI codes match with each other, switching to the alternative frequency.

3. The method of claim 2, further comprising:
determining (310), when the measured received signal strength of an alternative frequency is less than the valid received signal strength, whether the alternative frequency is the last alternative frequency in the accumulated alternative frequency list;
when the alternative frequency is the last alternative frequency:
deleting (312) the current accumulated alternative frequency list; and
receiving (302) the alternative frequency list at a predefined cycle; and
when the alternative frequency is not the last alternative frequency:
measuring (306) the received signal strength of the next alternative frequency.

4. A Radio Data System, RDS, apparatus (100) comprising:
an RDS tuner (110) arranged to receive a radio signal at a main frequency containing an alternative frequency list;
an RDS data processing unit (161) arranged to extract the alternative frequency list from the radio signal;
an accumulated alternative frequency list database (131) arranged to store an accumulated alternative frequency list including all previously received alternative frequency lists; and
a frequency switching module (162) arranged to:
establish (303) the accumulated alternative frequency list;
measure (302) a received signal strength of the main frequency at a predefined cycle;
compare (304) the received signal strength of the main frequency with a reference received signal strength; and
attempt, when the received signal strength of the main frequency is less than the reference received signal strength, to switch (309) to an alternative frequency in the accumulated alternative frequency list;
**characterized in that**
the frequency switching module (162) is further arranged to delete the accumulated frequency list when the received signal strength of each of the alternative frequencies in the accumulated frequency list is less than a predetermined valid received signal strength.

5. The RDS apparatus (100) of claim 4, wherein the frequency switching module (162) is further arranged to:
measure (306) the received signal strengths of the alternative frequencies in the accumulated alternative frequency list in sequence;
determine (310), when the measured received signal strength of an alternative frequency is less than the valid received signal strength, whether the alternative frequency is the last alternative frequency in the accumulated alternative frequency list;
delete (312), when the alternative frequency is the last alternative frequency, the accumulated alternative frequency list from the accumulated alternative frequency list database; and
measure (306), when the alternative frequency is not the last alternative frequency, the received signal strength of the next alternative frequency.

## Patentansprüche

1. Verfahren zum Verwalten von alternativen Frequenzlisten für ein Radiodatensystem, wobei das Verfahren aufweist:
ein Messen (302) einer empfangenen Signalstärke einer Hauptfrequenz, wobei die Hauptfrequenz eine aktuell empfangene Frequenz ist;
ein Empfangen (302) von mindestens einer alternativen Frequenzliste;
ein Erstellen (303) einer akkumulierten alternativen Frequenzliste, die alle früher empfangenen alternativen Frequenzlisten enthält;
ein Vergleichen (304) der empfangenen Signalstärke der Hauptfrequenz mit einer empfangenen Referenzsignalstärke;
und ein Versuchen, wenn die empfangene Signalstärke der Hauptfrequenz kleiner als die empfangene Referenzsignalstärke ist, auf eine alternative Frequenz in der akkumulierten alternativen Frequenzliste umzuschalten (309);
**dadurch gekennzeichnet, dass** ein Versuchen, auf die alternative Frequenz umzuschalten, ein Löschen der akkumulierten Frequenzliste aufweist, wenn die empfangene Signalstärke von jeder der alternativen Frequenzen in der akkumulierten Frequenzliste kleiner als eine vorbestimmte gültige empfangene Signalstärke ist.

2. Verfahren nach Anspruch 1, wobei ein Versuchen, auf die alternative Frequenz umzuschalten (309), aufweist:
ein nacheinander Messen (306) der empfangenen Signalstärken der alternativen Frequenzen in der akkumulierten alternativen Frequenzliste;
ein Bestimmen (308), wenn die gemessene empfangene Signalstärke einer alternativen Frequenz gleich oder größer als die vorbestimmte gültige empfangene Signalstärke ist, ob ein Programmidentifizierungs-, PI, Code der alternativen Frequenz mit dem PI-Code der alternativen Frequenz mit dem PI-Code der Hauptfrequenz übereinstimmt;
und wenn die PI-Codes übereinstimmen, ein Ausführen des Umschaltens (309) auf die alternative Frequenz.

3. Verfahren nach Anspruch 2, ferner aufweisend:
ein Bestimmen (310), wenn die empfangene Signalstärke einer alternativen Frequenz kleiner als die gültige empfangene Signalstärke ist, ob die alternative Frequenz die letzte alternative Frequenz in der akkumulierten alternativen Frequenzliste ist;
wenn die alternative Frequenz die letzte alternative Frequenz ist:
ein Löschen (312) der aktuellen akkumulierten alternativen Frequenzliste; und
ein Empfangen (302) der alternativen Frequenzliste in einem vorbestimmten Zyklus;
und wenn die alternative Frequenz nicht die letzte alternative Frequenz ist:
ein Messen (306) der empfangenen Signalstärke der nächsten alternativen Frequenz.

4. Radiodatensystem-, RDS, Vorrichtung (100), aufweisend:
einen RDS-Tuner (110), der angeordnet ist, um ein Radiosignal auf einer Hauptfrequenz zu empfangen, die eine alternative Frequenzliste enthält;
eine RDS-Datenverarbeitungseinheit (161), die angeordnet ist, um die alternative Frequenzliste aus dem Radiosignal zu extrahieren;
eine Datenbank der akkumulierten alternativen Frequenzliste (131), die angeordnet ist, um eine akkumulierte alternative Frequenzliste zu speichern, die alle früher empfangenen alternativen Frequenzlisten enthält;
und ein Frequenz-Umschaltemodul (162), das angeordnet ist zum:
Erstellen (303) der akkumulierten alternativen Frequenzliste;
Messen (302) einer empfangenen Signalstärke der Hauptfrequenz in einem vorbestimmten Zyklus;
Vergleichen (304) der empfangenen Signalstärke der Hauptfrequenz mit einer empfangenen Referenzsignalstärke;
und Versuchen, wenn die empfangene Signalstärke der Hauptfrequenz kleiner als die empfangene Referenzsignalstärke ist, auf eine alternative Frequenz in der akkumulierten alternativen Frequenzliste umzuschalten (309);
**dadurch gekennzeichnet, dass** das Frequenz-Umschaltemodul (162) ferner angeordnet ist zum Löschen der akkumulierten Frequenzliste, wenn die empfangene Signalstärke von jeder der alternativen Frequenzen in der akkumulierten Frequenzliste kleiner als eine vorbestimmte gültige empfangene Signalstärke ist.

5. RDS-Vorrichtung (100) nach Anspruch 4, wobei das Frequenz-Umschaltemodul (162) ferner angeordnet ist zum:
nacheinander Messen (306) der empfangenen Signalstärken der alternativen Frequenzen in der akkumulierten alternativen Frequenzliste;
Bestimmen (310), wenn die empfangene Signalstärke einer alternativen Frequenz kleiner als die gültige empfangene Signalstärke ist, ob die alternative Frequenz die letzte alternative Frequenz in der akkumulierten alternativen Frequenzliste ist;
wenn die alternative Frequenz die letzte alternative Frequenz ist, Löschen (312) der akkumulierten alternativen Frequenzliste aus der Datenbank der akkumulierten alternativen Frequenzliste;
und wenn die alternative Frequenzliste nicht die letzte alternative Frequenz ist, Messen (306) der empfangenen Signalstärke der nächsten alternativen Frequenz.

## Revendications

1. Procédé de gestion de listes de fréquences alternatives pour un système de données radio, le procédé comprenant :
la mesure (302) de l'intensité de signal reçue d'une fréquence principale, ladite fréquence principale étant une fréquence en cours de réception ;
la réception (302) d'au moins une liste de fréquences alternatives ;
l'établissement (303) d'une liste de fréquences alternatives accumulée comprenant toutes les listes de fréquences alternatives précédemment reçues ;
la comparaison (304) de l'intensité de signal reçue de la fréquence principale à une intensité de signal reçue de référence ; et
la tentative, lorsque l'intensité de signal reçu de la fréquence principale est inférieure à l'intensité de signal reçue de référence, de commutation (309) vers une fréquence alternative dans la liste de fréquences alternatives accumulée ;
**caractérisé en ce que** la tentative de commutation vers une fréquence alternative comprenant la suppression de la liste de fréquences accumulée lorsque l'intensité de signal reçue de chacune des fréquences alternatives dans la liste de fréquences accumulée est inférieure à une intensité de signal reçue valide prédéfinie.

2. Procédé selon la revendication 1, dans lequel la tentative de commutation (309) vers la fréquence alternative comprend :
la mesure (306) des intensités de signal reçues de fréquences alternatives dans la liste de fréquences alternatives accumulée en séquence ;
la détermination (308), lorsque l'intensité de signal reçue mesurée d'une fréquence alternative est supérieure ou égale à l'intensité de signal reçue valide, pour savoir si un code d'identification de programme (PI) de la fréquence alternative correspond au code PI de la fréquence principale ; et
l'exécution (309), lorsque les codes PI correspondent l'un à l'autre, d'une commutation vers la fréquence alternative.

3. Procédé selon la revendication 2, comprenant en outre :
la détermination (310), lorsque l'intensité de signal reçue mesurée d'une fréquence alternative est inférieure à l'intensité de signal reçue valide, pour savoir si la fréquence alternative est la dernière fréquence alternative dans la liste de fréquences alternatives accumulée ;
lorsque la fréquence alternative est la dernière fréquence alternative :
la suppression (312) de la liste de fréquences alternatives accumulée courante ; et
la réception (302) de la liste de fréquences alternatives à un cycle prédéfini ; et
lorsque la fréquence alternative n'est pas la dernière fréquence alternative :
la mesure (306) de l'intensité de signal reçue de la fréquence alternative suivante.

4. Appareil de système de radiocommunication de données (RDS) (100) comprenant :
un tuner RDS (110) conçu pour recevoir un signal radio à une fréquence principale contenant une liste de fréquences alternatives ;
une unité de traitement de données RDS (161) conçue pour extraire la liste de fréquences alternatives du signal radio ;
une base de données de listes de fréquences alternatives accumulées (131) conçue pour stocker une liste de fréquences alternatives accumulée comprenant toutes les listes de fréquences alternatives reçues ; et
un module de commutation de fréquence (162) conçu pour :
établir (303) le liste de fréquences alternatives accumulée ;
mesurer (302) une intensité de signal reçue de la fréquence principale à un cycle prédéfini ;
comparer (304) l'intensité de signal reçue de la fréquence principale à une intensité de signal reçue de référence ; et
tenter, lorsque l'intensité de signal reçue de la fréquence principale est inférieure à l'intensité de signal reçue de référence, de commuter (309) vers une fréquence alternative dans la liste de fréquences alternatives accumulée ;
**caractérisé en ce que** le module de commutation de fréquence (162) est en outre conçu pour supprimer la liste de fréquences accumulée lorsque l'intensité de signal reçue de chacune des fréquences alternatives dans la liste de fréquences accumulée est inférieure à une intensité de signal reçue valide prédéfinie.

5. Appareil RDS (100) selon la revendication 4, ledit module de commutation de fréquence (162) étant en outre conçu pour :
mesurer (306) les intensités de message reçues des fréquences alternatives dans la liste de fréquences alternatives accumulée en séquence ;
déterminer (310), lorsque l'intensité de signal reçue mesurée d'une fréquence alternative est inférieure à l'intensité de signal reçue valide, si la fréquence alternative est la dernière fréquence alternative dans la liste de fréquences alternatives accumulée ;
supprimer (312), lorsque la fréquence alternative est la dernière fréquence alternative, la liste de fréquences alternatives accumulée de la base de données de listes de fréquences alternatives accumulées ; et
mesurer (306), lorsque la fréquence alternative n'est pas la dernière fréquence alternative, l'intensité de signal reçue de la fréquence alternative suivante.
